# EUROPEAN PATENT APPLICATION

(11) **EP 2 444 993 A1**
(43) Date of publication of application: **25.04.2012**
(21) Application number: 10188415.3
(22) Date of filing: 21.10.2010
(51) Int. Cl.: H01L 21/00

(54) **Load lock chamber, substrate processing system and method for venting**

(71) Applicant: Applied Materials, Inc., Santa Clara, CA 95054 (US)
(72) Inventor: Gebele, Thomas, 63579 Freigericht (DE); Leipnitz, Thomas, 63755 Alzenau (DE); Buschbeck, Wolfgang, 63454 Hanau (DE); Bangert, Stefan, 36396 Steinau (DE); Lindenberg, Ralph, 63654 Büdingen - Rinderbügen (DE)
(74) Representative: Zimmermann & Partner

(57) **Abstract**

A lock chamber for a substrate processing system is provided which includes at least a first conduit adapted to provide an inner portion of the lock chamber in fluid communication with atmospheric pressure or overpressure. Additionally, the lock chamber includes at least a first control valve for controlling a flow rate of the fluid communication of the inner portion of the chamber with the atmospheric pressure or the overpressure, wherein the control valve is adapted to continuously control the flow rate. Furthermore, an according method, a computer program and a computer readable medium adapted for performing the method is provided.

## Description

### FIELD OF THE INVENTION

Embodiments of the present invention relate to a lock chamber, a substrate processing system, and a method for venting, in particular, of a lock chamber. Specifically, embodiments relate to an unload lock chamber and a method for venting an unload lock chamber. In particular, embodiments of the present invention relate to nano-manufacturing technology solutions involving equipment, processes, and materials used in the deposition of thin films and coatings with representative examples including (but not limited to) applications involving: semiconductor and dielectric materials and devices, silicon-based wafers, flat panel displays (such as TFTs), masks and filters, electrochromic coatings, energy conversion and storage (such as photovoltaic cells, fuel cells, and batteries), solid-state lighting (such as LEDs and OLEDs), magnetic and optical storage, micro-electromechanical systems (MEMS) and nano-electro-mechanical systems (NEMS), micro-optic and optoelectronic devices, architectural and automotive glasses, metallization systems for metal and polymer foils and packaging, and micro- and nano-molding.

### BACKGROUND OF THE INVENTION

Glass panels are coated, for example, in vacuum coating plants, under high-vacuum conditions, at pressures within the range of 5*10⁻⁴hPa to 3*10⁻² hPa. In order to increase the plant productivity and to avoid the requirement of having to evacuate the entire installation for each substrate and, especially, the high-vacuum section, load and unload locks are used for the substrates.

In order to improve the material flux rate and increase the productivity in modem in-line coating plants, separate load and unload lock chambers are being used. A simple so-called 3-chamber coating unit consists of a load lock, in which the substrate is pumped from atmospheric pressure to an adequate transition pressure of, for example, between p=1*10⁻³ hPa to p=5*10⁻² hPa, of a sequential vacuum coating section (process chamber) and an unload lock, in which, by means of ventilation, said substrate is again adjusted to the atmospheric pressure level.

The task of load lock chambers is to evacuate to a sufficient and low enough transition pressure to the process range as quickly as possible. The task of unload lock chambers is to vent as quickly as possible to atmospheric pressure. Then, after the substrate is unloaded from the unload lock chamber, it is evacuated again.

A factor in productivity and concurrent economical utilization of an in-line coating unit is the so-called cycle, i.e., station time, i.e., the time which has to be used per batch of substrate before the next batch of substrate may be introduced into the unit, or the average processing time per substrate batch under continuous operating conditions. In order to achieve, for example, a cycle time of 45 seconds, the lock chamber must be in condition to deliver within t<=45 seconds a substrate from a given atmospheric point A to a given point B within the (high) vacuum range, and vice versa. For this purpose, the system must transport said substrate into and out of the lock chamber, respectively, evacuate and ventilate said lock chamber, respectively, and open and eventually close all applicable valves, respectively. This means that in such a case, the time available for evacuation and venting must always be smaller than the cycle time (for example, 20 s or 45 s), since all other tasks (see above) have to be accomplished within said cycle time.

According to the known relation that the pumping time is directly proportional to the ratio of volume V to pumping speed S, it becomes evident that there are basically two possibilities to reduce the pumping time, and consequently the cycle time: either the volume reduction of the lock chamber; or the increase of the pumping capacity coupled to the lock chamber.

Modern lock chambers thus include a small volume resulting in a reduction of the pump time, other things being equal. However, fast venting, in particular in volume reduced chambers, results in increased pressure differences within the lock which may lead to misalignment, damage to or even destruction of the substrates.

In order to prevent the substrates from being damaged, so-called "vent showers" are used for distributing the gas flow and for generating a homogenous flow of gas into the chamber. Furthermore, it is possible to position the nozzles or vent showers with their outlets oriented against chamber walls or other equipment within the chamber so that a direct gas flow towards the substrate is prevented. It is also known to subsequently open further nozzles thereby increasing the flow rate in a stepwise manner. This is sometimes called "soft venting". Also, one of the inventors had already proposed to position the substrates between two flow streams, which are oriented opposite to each other. However, the proposed measures are still either too slow, or the damage rate of the substrates to be coated remains too high.

### SUMMARY

In light of the above, according to an aspect described herein, a lock chamber for a substrate processing system is provided which includes at least a first conduit adapted to provide an inner portion of the lock chamber in fluid communication with atmospheric pressure or overpressure. Additionally, the lock chamber includes at least a first control valve for controlling a flow rate of the fluid communication of the inner portion of the chamber with the atmospheric pressure or the overpressure, wherein the control valve is adapted to continuously control the flow rate.

According to a further aspect, a substrate processing system is provided with at least one lock chamber as described herein and a chamber for coating a substrate.

According to a further aspect, a method of venting a load lock chamber is provided. The method includes providing a flow rate profile for venting the load lock chamber and controlling a first control valve being adapted to continuously control the flow rate according to the flow rate profile for venting the load lock chamber.

According to a further aspect, a computer program is provided including computer program code means adapted to perform all the steps of the method described herein when the program is run on a computer.

According to a further aspect, a computer-readable medium storing the computer program as described herein is provided.

According to a further aspect, a computer-readable medium containing media data and information which indicates how to vent a lock chamber is provided. The medium includes means for providing a flow rate profile for venting the lock chamber; and means for controlling a first control valve being adapted to continuously control the flow rate according to the flow rate profile for venting the lock chamber.

According to an aspect, the lock chamber as described is an unload lock chamber.

Embodiments are also directed to methods for manufacturing and operating the lock chamber or the substrate processing system. These method steps may be performed manually or automatically, e.g. controlled with a computer programmed by appropriate software, by any combination of the two or in any other manner.

Further advantages, features, aspects and details that can be combined with embodiments described herein are evident from the dependent claims, the description and the drawings.

### BRIEF DESCRIPTION OF THE DRAWINGS

So that the manner in which the above mentioned features of the present invention can be understood in detail, a more particular description of the invention, briefly summarized above, may be had by reference to embodiments of the invention. The accompanying drawings relate to embodiments of the invention and are described in the following:
Figs. 1-8 illustrate lock chambers according to embodiments described herein;
Fig. 9 illustrates a substrate processing system according to embodiments described herein;
Fig. 10 illustrates a multitude of lock chambers according to embodiments described herein;
Fig. 11 illustrates a substrate processing system according to embodiments described herein; and
Fig. 12 illustrates an exemplary pressure-time diagram used for controlling the control valve according to embodiments described herein;
Fig. 13 illustrates a lock chamber according to embodiments described herein; and
Fig. 14 illustrates an exemplary flow rate-time diagram illustrating the use of several valves according to embodiments described herein.

### DETAILED DESCRIPTION OF THE INVENTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on, or in conjunction with, other embodiments to yield yet a further embodiment. It is intended that the present invention includes such modifications and variations.

Within the description of the drawings, the same reference numbers refer to the same components. Generally, only the differences with respect to the individual embodiments are described. Drawings are not necessarily true to scale and features may be exaggerated for illustrational purposes.

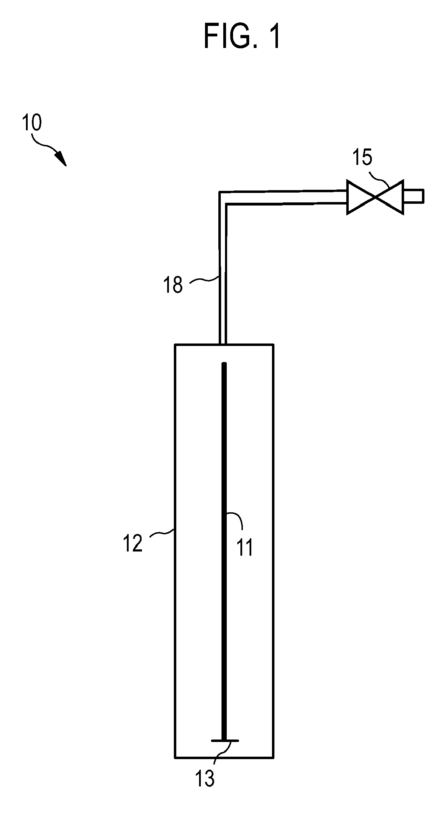

Fig. 1 shows a lock chamber according to embodiments. The lock chamber 10 includes an inner portion 12 within which a substrate 11 is shown for illustrative purposes. Typically, the substrate 12 is positioned on a carrier 13 (which, for illustrative purposes, has been omitted in the following drawings). The lock chamber 10 further includes a first conduit 18 to provide the inner portion 12 of the lock chamber 10 in fluid communication with atmospheric pressure, such as, with the ambient air.

Generally, and not limited to this embodiment, it is possible that overpressure is provided instead of atmospheric pressure. The term "overpressure" shall refer to pressure which is larger than atmospheric pressure. The overpressure can be provided by a tank being filled with, for instance, conditioned dry air ("CDA"), nitrogen (N₂), or the like. Both the atmospheric pressure and the overpressure shall be referred to as "outside pressure" hereafter.

Fig. 1 further illustrates a first control valve 15 for controlling a flow rate of the fluid communication of the inner portion 12 of the lock chamber 10 with the outside pressure. The first control valve 15 is adapted to continuously control the flow rate.

As used herein, the term "lock chamber" shall refer to a chamber used in vacuum applications adapted for enclosing at least one substrate and amending the pressure within the chamber. The term "load lock chamber" shall refer to a lock chamber configured to bring a substrate from higher pressure to a lower pressure. The pressure is typically amended to a pressure of between 1*10⁻³ hPa and 5*10⁻² hPa. The term "unload lock chamber" shall refer to a lock chamber configured to vent a substrate, i.e., to bring a substrate from lower pressure to higher pressure. Typical lock chambers have an inlet seal by means of which the substrate is received, and an outlet seal, through which the substrate is unloaded. For instance, in the event of a unload lock chamber, the inlet seal is typically connected to a coating chamber (and thus vacuum pressure) whereas the substrate is exited to atmospheric pressure through the outlet seal. The terms "coating chamber" and "processing chamber" are used synonymously herein and shall refer to chambers including equipment for coating a substrate.

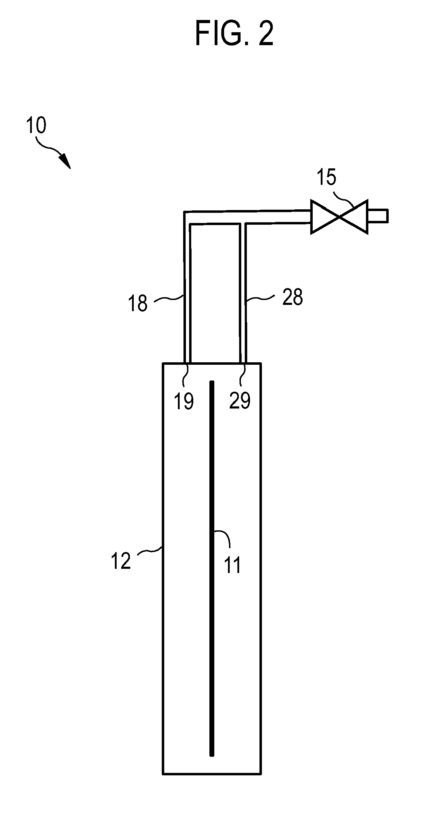

Fig. 2 is a further illustration of embodiments described herein. Whereas in the embodiments according to Fig. 1 only one conduit 18 is provided, the lock chamber 10 may typically be provided with two or even more conduits for providing the inner 12 part of the lock chamber with outside pressure. Typically, an even number of conduits is provided.

As shown in the embodiments illustrated in Fig. 2, the first conduit 18 and a second conduit 28 are provided. Typically, and not limited to this embodiment, in the event of two or more conduits, their inlet into the inner part is positioned symmetrically to the position of the substrate. According to embodiments, the distance between each inlet and the substrate is identical. Additionally or alternatively, they are positioned and oriented such that the flow exiting from the respective inlets is directed to different sides of the substrate. In the embodiments of Fig. 2, the inlets are referred to by reference numbers 19 and 29. Although existent, the inlets are not specifically shown in the other drawings.

It is possible that one control valve is provided controlling the at least one conduit. For instance, as it is illustrated in Figs. 1 and 2, the control valve 15 controls both the first conduit 18 and the second conduit 28. The one control valve governing the flow rate of several conduits shall be called "common control valve" herein. Given an identical conduit design of the several conduits 18 and 28, this allows providing the same flow rate into the chamber at each inlet 19 and 29.

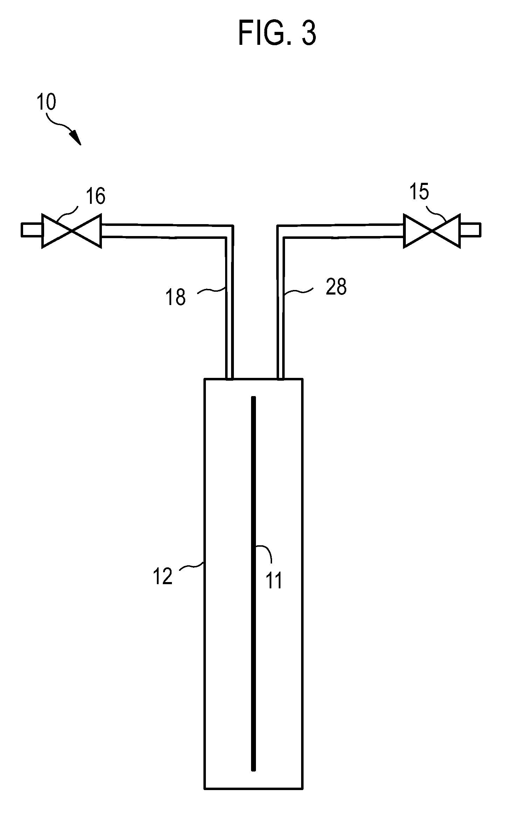

Alternatively or additionally to a common control valve, it is possible that each conduit is controlled by a separate control valve. For instance, Fig. 3 illustrates embodiments wherein each of the conduits 18 and 28 are provided with a separate control valve 15 and 16. The provision of separate control valves allows the individual control of the flow rate through each conduit. This may be particularly useful if, for instance, differing conduit set-ups have to be accounted for. Also, the individual control allows for reacting to substrate vibrations or the like. An individual control is typically suitable for providing different flows to different sides of the substrate.

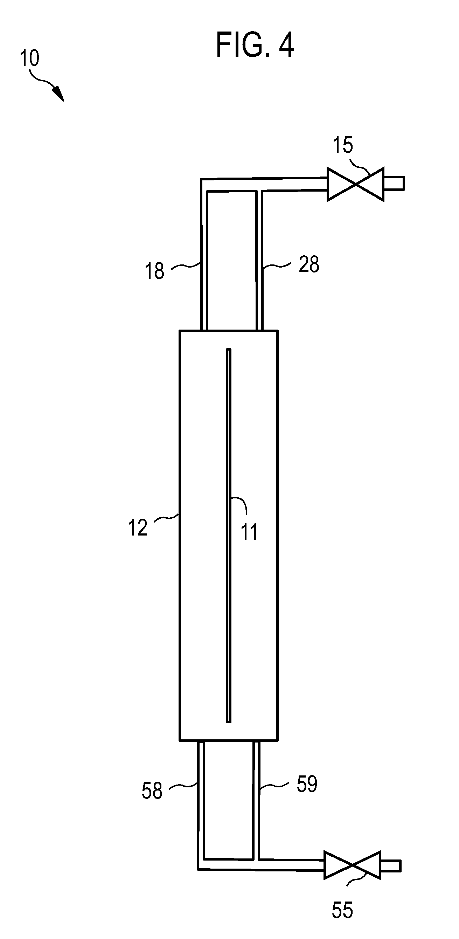

As illustrated in some embodiments described herein, the at least one conduit may be positioned in such a way that it vents the inner part of the chamber from the top side of the chamber's inner part. According to other embodiments, the inner part of the chamber may be vented from the bottom side. As it is illustrated in Fig. 4, one or more conduit may be provided on both the top side and bottom side. In the embodiments of Fig. 4, the conduits 18 and 28 are commonly controlled by the valve 15 and provide a flow at the top of the inner part 12 of the lock chamber 10. Additionally, the conduits 58 and 59 are commonly controlled by the valve 55 and provide a flow at the bottom of the inner part 12. Alternatively to the depicted embodiments, it is possible to control each conduit separately by a respective valve, or to control all the conduits commonly by only one valve.

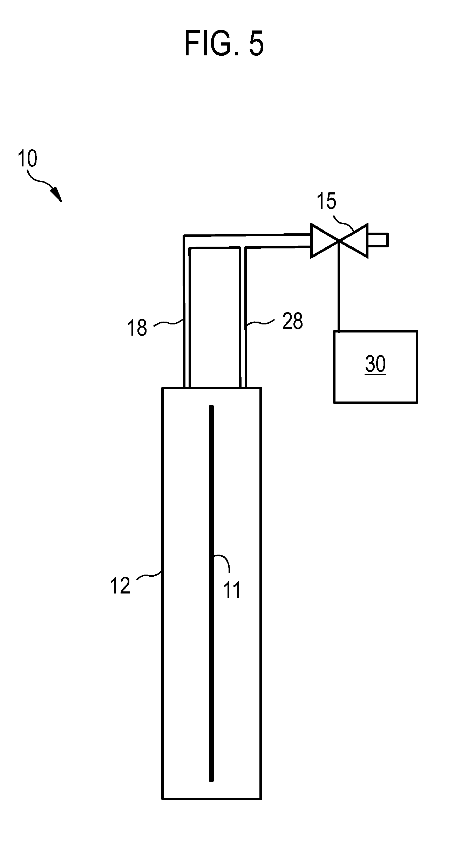

Typically, a controller for control of the at least one valve is provided. Fig. 5 illustrates the provision of a controller 30 for controlling the flow rate through the at least one conduit. According to embodiments described herein, the controller is connected with the one or more control valves.

The controller calculates the optimum flow rate and controls the at least one control valve accordingly. The controller may be, for example, a computer comprising an input unit such as a mouse and/or a keypad; a display unit such as a screen; a computing unit such as a CPU (central processing unit) and a memory unit such as a non-volatile memory, for example, a hard disk; and/or a volatile memory such as a RAM (random access memory). The controller is typically provided with a computer program including computer program code means for calculating the optimum flow in dependence on the time and/or for controlling the at least one valve. The computer program may be provided on a computer-readable medium, such as a hard-disk of the computer, or on an external memory, such as on a memory stick, a CD, a DVD, or the like.

According to embodiments, measurement units may be provided. The measurement unit may be one or more of a position sensor, a pressure sensor, a flow rate sensor, a vibration sensor, a temperature sensor or the like. In particular, the measurement unit may be one or more of a capacitive sensor, inductive sensor, or an optical sensor such as a laser distance sensor or a deflection sensor. For instance, the measurement unit may be a stress sensor that is optionally connected to the carrier or the substrate in a wireless way. The measurement unit is typically provided within the inner part of the chamber. However, it is also possible to provide the measurement unit e.g. on a conduit, or outside the inner part of the lock chamber. For instance, a position sensor could sense the position from outside, e.g., by measuring the distance optically through a window located at the chamber's inner part wall.

The use of one or more measurement units allows a feedback control of the control valves. For this purpose, the one or more measurement units are typically connected to the controller to which it/they provide measured information. Typically, the measurement data is provided to the controller constantly. The controller typically accounts for the measurement information, e.g., for the calculation of the optimum flow curve.

In particular, the flow rate sensor could include a pendulum, at the end of which a disc is attached. The deflection of the pendulum can be measured with an angle sensor or with a distance sensor. The deflection allows the deduction of the force exerted by the streaming gas. The damping and the reset force can be influenced by weights and/or an elastic unit such as a spring. Typically, the signal received by the flow rate sensor is used for the calculation of the optimum flow rate.

For instance, instead of always using the same flow rate curve for controlling the one or more valves, it is possible to adapt the optimum flow rate to each specific venting process. As a result, the position of the substrate and/or the carrier with one or more sensors may be measured. The measurement information is provided to the controller. The controller may react instantly to the measured information, e.g., by reducing the flow rate in the event of oscillations or displacements. Once the oscillations are softened, the controller may increase the flow rate again. Thus, it is possible to react proactively to critical situations during substrate venting in order to prevent substrate damage and destruction.

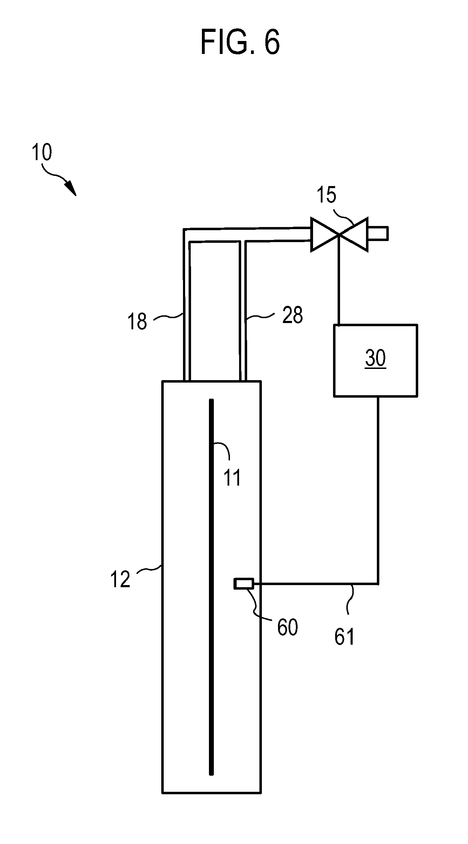

Fig. 6 illustrates the provision of a position sensor 60. Typically, and not limited to the embodiment of Fig. 6, the measurement unit is connected to the controller in order to provide measurement information to the controller. In Fig. 6, this connection is shown by line 61. The controller is typically connected to all of the at least one control valve. Typically, the output of the controller controls the valve setting so that the flow through the respective conduits is controlled in a predetermined fashion, for example, according to an optimized curve as described herein.

Within the present disclosure, the connections from and to the controller may include any kind of direct or indirect data lines, for example, via cables or via wireless data connection. For instance, it is possible that the controller and/or the at least one measurement unit are connected to each other via a network, such as a local area network (LAN), in particular by a wireless local area network (WLAN).

For instance, in the embodiment illustrated in Fig. 6, the shown sensor could be a position sensor. The position sensor allows the controller to gain information about the actual position of the substrate and/or the carrier, e.g., determined at the substrate center and/or a non-centric position of the substrate and/or the carrier, in particular on whether, and if so, how much the substrate and/or the carrier oscillate.

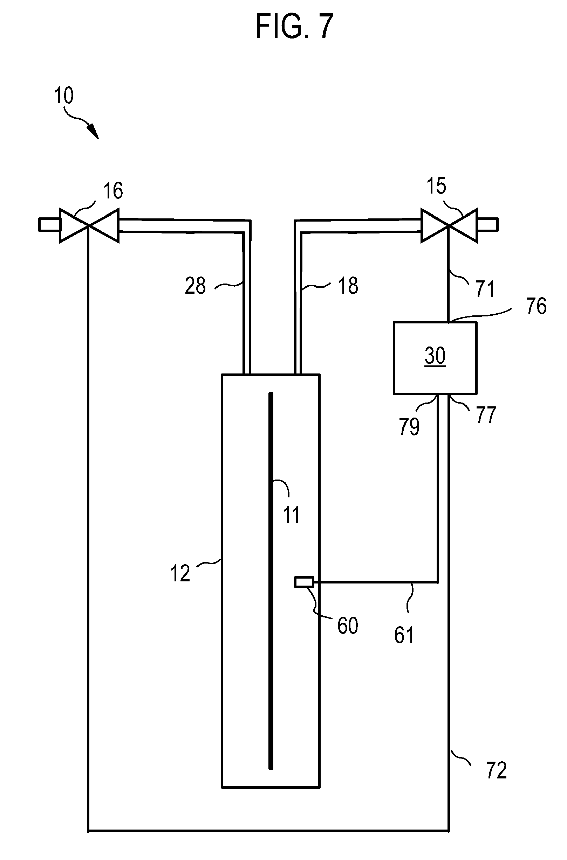

The embodiments illustrated in Fig. 7 exemplarily show the connection of the controller 30 with the valve 15 via data line 71, the connection of the controller 30 with the valve 16 via data line 72, and the connection of the controller 30 with the sensor 60 via data line 61. The data line references have been omitted in other drawings for the sake of clarity of the drawings. Typically, the controller is provided with at least one output to be connected to the at least one valve. In Fig. 7, the controller outputs 76 and 77 are illustrated. According to embodiments, the controller has, in additional, at least one input for a connection with, for instance, at least one measurement unit. In Fig. 7, the input is illustrated and referred to as reference number 79.

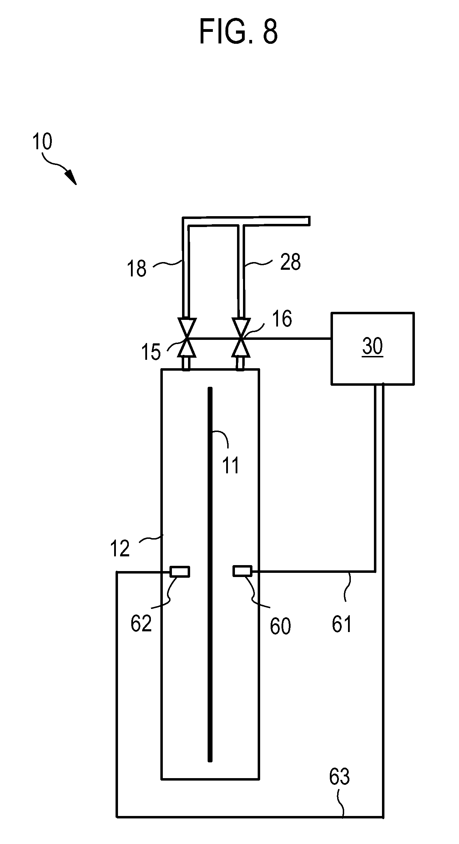

The embodiments of Fig. 8 illustrate the provision of two measurement units within the inner part of the lock chamber. In Fig. 8, the two measurement units are sensors referred to with reference numbers 60 and 62. They are connected to the controller 30 via the data lines 61 and 63, respectively.

For instance, the two sensors 60 and 62 of Fig. 8 could be pressure sensors allowing the measurement of the pressure on both sides of the substrate. The pressure difference between the two sides of the substrate can be calculated, e.g., in the controller, and considered in the further calculation of the optimized flow rate. In particular, the results may be used for the individual control of the flow rate through the first conduit 18 and the second conduit 28. For example, if the pressure sensor 60 measures a lower pressure than the sensor 62, as a result, the controller 30 might control the first control valve 15 and the second control valve 16 in such a way that the flow rate through the conduit 18 is smaller compared to the flow rate through the conduit 28 until the two pressure sensors measure a comparable pressure again. Generally, the one or more measurement unit is typically positioned in close distance to the substrate, i.e., at a distance less than 10cm.

A similar control of the individual flow rates as described with respect to the embodiments of Fig. 8 can be triggered by a position sensor as mentioned previously, in particular with respect to the embodiments illustrated in Fig. 6. The position sensor may indicate the controller on the exact position of the substrate at each point in time. As a result, it may particularly provide information to the control as to how much the substrate is deflected from its rest position. Thus, the controller may account for this measurement information in the individual control of the control valves.

It is important to note that the at least one control valve of the present disclosure is configured to control the flow rate continuously. Hence, the control valves as described herein can also be called "flow rate adjusting valves". That is, in contrary to known valves used in lock chambers only allowing either the closing or the complete opening of the conduit ("on/off-valves"), the flow rate can be adjusted continuously, typically between 0% (valve closed) and 100% (valve completely opened). For instance, a typical small flow rate is in the range of between 0.01Nm³/s and 0.05 Nm³/s, such as 0.025 Nm³/s. A typical high flow rate is in the range of between 0.1 Nm³/s and 1.0Nm³/s, such as 0.4Nm³/s. Typically, the flow rate can be continuously adjusted between values of 0.01 Nm³/s and 1.0 Nm³/s. The unit Nm³/s refers to normalized cubic meter per second, wherein the normalization refers to the standard pressure of 1 atm (approx. 10⁵ Pa). Since the exact control of the flow rate is of importance, according to embodiments, the valves used can be adjusted with a precision of +/- 10%, typically of +/-5%.

The continuous control of the flow rate allows adjusting it to the optimum value during the complete venting process. Whereas "soft venting" as it is known to the inventors employs a subsequent opening of additional valves, thus resulting in a sudden increase of the flow rate, embodiments of the present disclosure allow for the provision of a continuous increase of the flow rate.

The allowed force on the substrate depends particularly on its size and thickness. The allowed force on the substrate is typically a known parameter in the coating process. Given the allowed force on the substrate, the maximum allowed value of the flow rate can be calculated for controlling the continuous flow rate. This calculation is typically undertaken for each moment in time of the venting.

For instance, given the overall time interval for the venting process, the optimum flow rate is calculated by minimizing the product of the pressure of the venting gas and the square of the flow speed of the venting gas. The flow speed of the venting gas as understood in this context is the flow speed of the venting gas when striking the substrate. According to a simplified model, the flow speed is determined as the speed with which the gas exits the aperture of the nozzle(s). Consequently, it is assumed that the particles impinge on the substrate or the carrier with this speed. Hence, for instance, in case the flow nozzle(s) direct(s) the gas towards the chamber's inner part walls, the resulting flow speed of the gas striking the substrate is of relevance.

The at least one control valve is continuously operated. Typically, the at least one control valve is steadily opened, e.g. from 0% at the beginning of the venting process until 100% at the end of the venting process. Typically, the control is such that the force acting on the substrate is constant during the complete venting process. The curve indicating the control of the control valve is typically steady without any discontinuous steps in the curve.

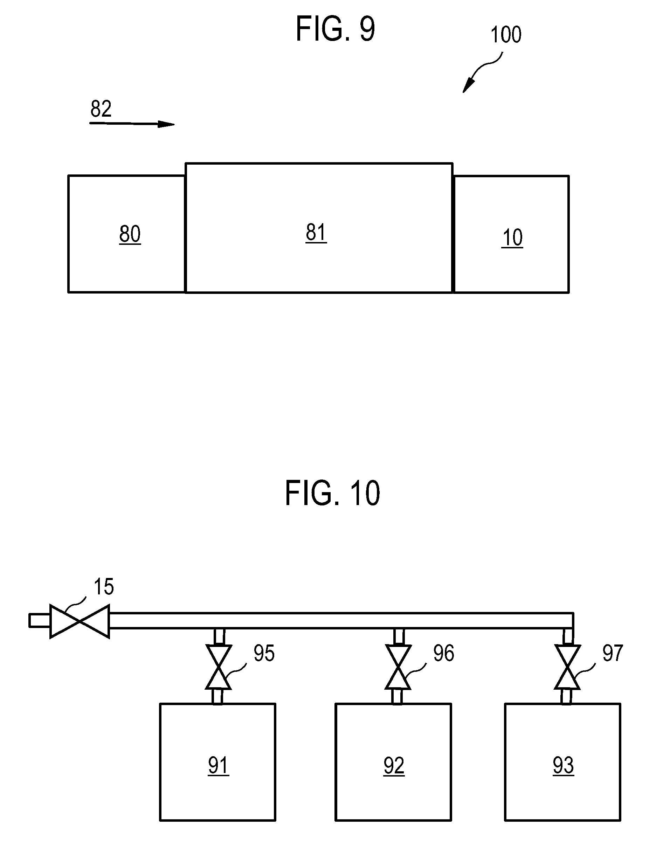

Referring now to Fig. 9, a substrate processing system 100 is shown. The substrate processing system includes one lock chamber 10 as described herein, in particular with respect to the Figures 1-8. According to embodiments, the lock chamber 10 is an unload lock chamber. Alternatively, it is possible that the substrate processing system includes more than one lock chamber as described. The substrate processing system typically includes a load lock chamber 80 for loading substrates and providing a vacuum environment to the substrates. After evacuating the load lock chamber 80, the substrates are moved into the coating chamber 81. The term "coating chamber" as used herein shall refer to one or several consecutive chambers adapted for coating a substrate. The substrates are coated in the coating chamber by, e.g., sputtering or evaporating. Thus, thin layers are deposited on the substrates.

The movement direction is indicated by the arrow 82 in Fig. 8. After the coating, the substrates are moved into the lock chamber 10 which typically works as an unload lock chamber. That is, the substrate is positioned in the lock chamber with the pressure being substantially equal or identical to the pressure within the coating chamber. Vacuum as used herein shall refer to pressures of below 5*10⁻² hPa. Once the seal between lock chamber 10 and coating chamber 81 is closed, the lock chamber 10 is vented. Venting typically continues until atmospheric pressure within the lock chamber is reached. Once atmospheric pressure is reached, the substrate is unloaded from the lock chamber.

After that, the seals of the lock chamber are closed again and the chamber is evacuated with no substrate present. Since no substrate is present, the only limiting factor in evacuating the chamber is the power of the evacuating pumps. Once vacuum pressure is reached, i.e. a pressure similar or equal to the pressure present in the coating chamber, the lock chamber is ready for receiving a coated substrate in order to manage the transfer to atmospheric pressure again.

According to embodiments, the lock chamber disclosed herein is capable of handling large area substrates, typically having a size of larger than 1m times 1m, equal or larger than 2.2 m times 2.2 m, or even equal to or larger than 3.0 m times 3.0 m. Typically, the thickness of the substrates is below 1 mm, even more typically equal to or below 0.7 mm, or even equal to or below 0.5 mm.

Typically, the term "substrate" as used herein refers to inflexible substrates, such as, wafers or a glass plate. Representative examples for substrates include (but are not limited to) applications involving: semiconductor and dielectric materials and devices; silicon-based wafers; flat-panel displays (such as TFTs); masks and filters; energy conversion and storage (such as photovoltaic cells, fuel cells, and batteries); solid-state lighting (such as LEDs and OLEDs); magnetic and optical storage; micro-electro-mechanical systems (MEMS) and nano-electro-mechanical systems (NEMS); micro-optic and opto-elecro-mechanical systems (NEMS), micro-optic and optoelectronic devices; transparent substrates; architectural and automotive glasses; metallization systems for metal and polymer foils and packaging; electrochromicly coated substrates; and micro- and nano-molding.

The substrates, e.g. the glass panels, are typically coated in vacuum coating process systems, under high-vacuum conditions, at pressures within the range of 5*10⁻⁴ hPa to 3*10⁻² hPa, especially within the range of 2*10⁻³ hPa to 2*10⁻² hPa for sputtering processes.

According to embodiments described herein, the lock chamber is an unload lock chamber. The lock chamber is typically configured to allow a substrate in low pressure environment to become the substrate in atmospheric pressure. Normally, this transition of the pressure is undertaken within a predetermined time interval. The predetermined time interval is typically below 30 seconds, more typically below 15 sec or even below 10 sec. According to embodiments, the time necessary for venting the unload lock chamber and the time necessary for evacuating the load lock chamber are equal, in particular in case of fast evacuating systems. The shorter the time interval for venting the substrate is, the faster the lock chamber can be brought to low pressure again in order to receive a further substrate.

The embodiments illustrated in Fig. 10 schematically show a multi-chamber inline system. Accordingly, the perspective details three lock chambers with respective inner parts 91, 92, and 93. Typically, the multitude of lock chambers are unload lock chambers. The further coating chambers and the load lock chambers are positioned behind the unload lock chambers, so it is not possible to recognize them from this perspective. Fig. 10 thereby illustrates that, according to embodiments described herein not limited to Fig. 10, the substrate processing system may include several processing lines so that a multitude of substrates can be processed in parallel. As illustrated in Fig. 10, each lock chamber may be provided with one or more separate control valves 95, 96, and 97 for controlling the gas flow into the inner parts 91, 92, and 93 of each of the lock chambers. Alternatively, or additionally (see Fig. 10), a common control valve 15 may be provided controlling the conduit leading to all lock chambers.

It is also possible that one or more coating chambers are equipped as lock chambers as described herein. Thus, the coating chambers can be vented with gas as described herein. Typically, a coating chamber is vented in specific time intervals, for instance, for maintenance, cleaning, or replacing coating elements, and in the event of an unforeseen event such as an operational disturbance. Venting a coating chamber has to be done with caution in order not to raise dust which causes damage, e.g., in the vacuum pumps. Thus, venting the coating chamber according to the method as described herein would allow for optimized venting. Typically, venting the coating chamber takes up to 10-15 minutes so that it is undertaken much slower than venting the unload lock chamber during a coating process. Whereas in the art known to the inventors, venting the coating chamber is presently undertaken by means of subsequently opened valves and apertures, according to embodiments of the present disclosure, the multitude of valves and/or apertures can be reduced and replaced by at least one valve controlled as described herein.

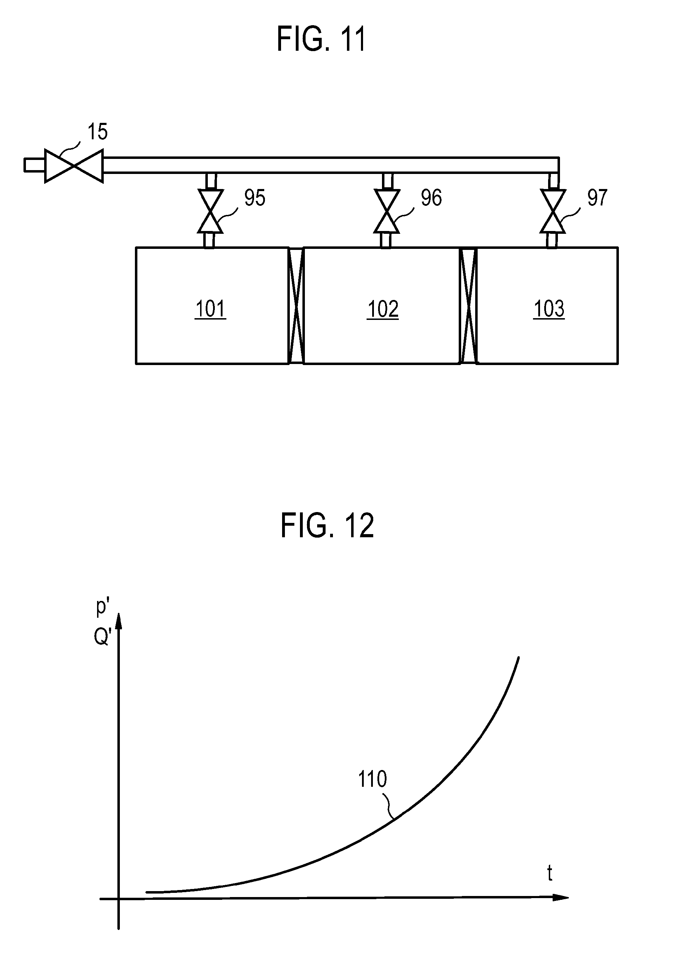

Fig. 11 shows an embodiment wherein one or more coating chambers 102 are equipped as lock chambers as described herein. In the exemplary embodiment of Fig. 11, substrates are entered to load lock chamber 101 and forwarded to the coating chamber 102. According to embodiments, one or more further coating chambers may be provided, e.g., a second, third, fourth or even more coating chambers. A separate control valve may be provided for each of the coating chambers. In the embodiment illustrated in Fig. 11, the control valve 96 is provided for controlling the gas flow to the coating chamber 102. After passing the coating chambers, the substrates are typically transported to the unload lock chamber 103 where they are vented as described herein.

According to the embodiment of Fig. 11, a common control valve 15 is provided which is adapted for controlling the gas flow to several chambers, typically all of the chambers. For instance, the control valve may be adapted for controlling the gas flow to the load lock chamber, the processing chamber(s), and the unload lock chamber (as illustrated in Fig. 11). Alternatively or additionally, each chamber may be provided with a control valve. In the illustrative example of Fig. 11, the load lock chamber 101 is provided with control valve 95, the processing chamber 102 is provided with control valve 96, and the unload lock chamber 103 is provided with control valve 97.

The control valve as provided herein is adapted to continuously control the gas flow to the connected chamber. As illustrated in some embodiments, it is further possible that additional control valves are provided (see, for instance, Figs. 10 and 11). In particular in those embodiments it is typical that the common control valve is adapted for continuously controlling the gas flow (reference number 15 in Figs. 11 and 12), whereas the other control valves may be replaced with on/off-valves (reference numbers 95, 96, and 97 in Figs. 11 and 12).

An "on/off-valve" refers to a valve with only two controllable states: In the on-position, the valve is completely open, whereas it is completely closed in the off-position. The expression "common control valve" refers to a control valve which is in fluid connection to at least two gas flow inlets, in particular to at least two gas flow inlets of at least two chambers.

Hence, generally and not limited to the embodiments explicitly illustrated in the drawings, it is typical to provide at least one common control valve adapted for continuously controlling the gas flow, and at least one on/off-valve. Since the control valves as described herein are, in general, essentially more expensive than on/off-valves, it is possible to continuously and individually control the gas flow to several chambers (for instance, n chambers) by the provision of one control valve and several on/off-valves (for instance, n on/off-valves).

A computer program may be implemented for the control of the gas flow. The computer program controls at least one control valve that is adapted to continuously control the flow rate according to the flow rate profile for venting the lock chamber.

According to embodiments, the computer program controls the gas flow to a multitude of gas flow inlets. Typically, the gas flow inlets are provided in separate chambers. The computer program is typically adapted to control at least one control valve that is adapted to continuously control the gas flow. Additionally, the computer program may be adapted to control at least one on/off-valve. For instance, n chambers may be provided with one common control valve for continuously controlling the gas flow and n on/off-valves. The computer program typically retrieves data on the optimized venting curve (e.g., from a data storage device such as a hard disk) or calculates the optimized venting curve for each of the n chambers. According to embodiments, the computer program controls the venting of the n chambers accordingly.

For instance, m of the n chambers shall be vented at the same time. For illustrative purposes let n=5 and m=3 wherein the chambers m1, m2, and m3 shall be vented and k1, and k2 shall not be vented. The computer program shuts the on/off-valves of the chambers k1 and k2, and opens the on/off-valves of the chambers m1, m2, and m3. Then, the control valve is opened wherein the flow rate is continuously increased. Thus, the chambers m1, m2, and m3 are vented.

According to another example, if the first, second, and third chambers are vented according to their numbering, only the on/off-valve of the first chamber will be in an open position during continuous increase of the flow rate by means of the common control valve as described herein. Once this has been accomplished, only the on/off-valve of the second chamber will be in an open position during continuous increase of the flow rate by means of the common control valve as described herein. Once this has been accomplished, only the on/off-valve of the third chamber will be in an open position during continuous increase of the flow rate by means of the common control valve as described herein. This may be controlled manually, or by a computer program.

It is possible that a venting profile for each chamber is stored in a memory. The computer program having the task to vent specific chambers at the same time, retrieves the profile of the specific chambers from the memory and vents these chambers according to the profile with the smallest pressure rise velocity. According to embodiments, the venting may be undertaken according to the profile with the longest venting time.

Fig. 12 schematically shows the relation of the pressure raise velocity p' within the inner part of the lock chamber in dependence of the time during venting. The pressure raise velocity is defined as the derivative of the pressure p with respect to the time t, that is, dp/dt. The overall time necessary for venting the chamber according to embodiments described herein is below 20 sec, more typically below 10 sec, or even below 5 sec. The pressure is at vacuum level when the substrate is moved to the unload lock chamber after the coating process. As described herein, the pressure is increased by venting the chamber, i.e., by continuously controlling the control valves for supplying gas to the inner part of the unload lock chamber. Since the valve opening is typically increased, also the pressure raise velocity p' is increased. The resulting pressure raise velocity p' is shown in Fig. 10 and referred to as reference number 110.

Since Fig. 12 is a qualitative diagram, and given the direct proportionality of the flow rate Q' (i.e. the derivative of the gas amount Q with respect to the time t, that is, dQ/dt. In this regard please note the relation dQ/dt=dp/dt*V with V being the volume of the chamber) and to the pressure raise velocity p', Fig. 12 and reference number 110 also represent the schematic flow rate curve in dependence of the time.

The flow rate of the at least one control valve can be adjusted continuously between a minimum value and a maximum value. The minimum value may be 0% (valve closed), but it is also possible that the minimum value will be larger than 0% or larger than 1% but typically smaller than 10% or even 5%. The maximum value may be 100% (valve completely opened), but it is also possible that the maximum value will be smaller than 100% (e.g., smaller than 95% or 90%) but typically larger than 80%. There may be manifold reason for this. For instance, a continuous control in the value range close to 0% (or 100%) can require a high-end technology. The costs may not be balanced with the advantage over a minimum value somewhat larger than 0% (or a maximum value somewhat smaller than 100%).

In particular in those embodiments with a minimum value differing from 0% and/or a maximum value differing from 100%, but also in all the other embodiments described herein, it possible that at least one additional on/off-valve will be provided. For instance, the on/off-valve may be adapted for providing a comparably small gas flow (e.g. below 10% or 5% of the gas flow fed to the on/off-valve). Such a valve shall be called "low flow rate valve". Alternatively, the on/off-valve may be adapted for providing a comparably large gas flow (e.g. at least 50%, 80% or 90% of the gas flow fed to the on/off valve). Such a valve shall be called "high flow rate valve". It is also possible, that both an on/off-valve for a small gas flow (low flow rate valve) and an on/off-valve for a large gas flow (high flow rate valve) will be provided.

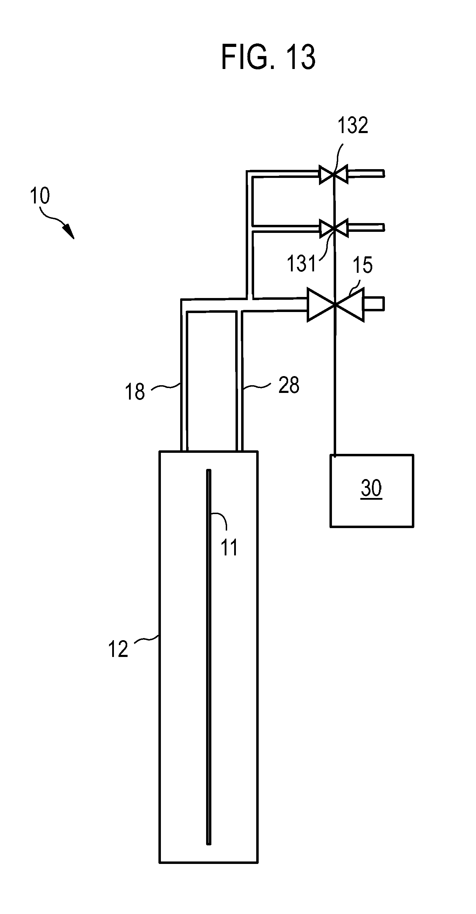

Fig. 13 shows an embodiment including two additional on/off-valves 131 and 132. The on/off-valves are typically connected to the controller 30 via a data line. One of the two on/off-valves may be a low flow rate valve, the other one may be a high flow rate valve.

According to an embodiment, venting is undertaken as follows: First, low flow rate valve is switched on thereby starting the venting. After a predetermined time interval, the continuous increase of the flow rate via the controllable valve is initiated up to the maximum flow rate of the controllable valve. Typically, the low flow rate valve remains in an open position during the complete venting. At the end of the venting process, the high flow rate valve is switched on allowing a large gas flow to enter the chamber.

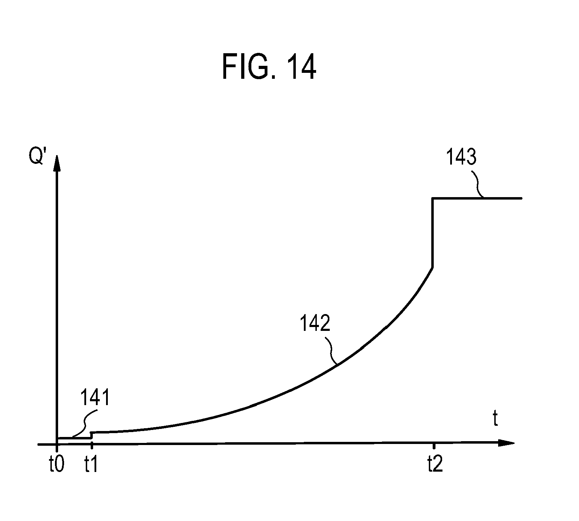

Fig. 14 shows a schematic flow rate diagram of such an embodiment. At the time t0, the low flow rate valve is opened. It may be closed again at time t1 or it may remain open during the further venting process. After the time t1, the controllable valve is opened and its gas flow rate is continuously increased to time t2. Typically, at that time the maximum value of the controllable valve is reached. In order to accelerate the outstanding venting, the high flow rate valve is opened at time t2 allowing a very large flow rate to vent the chamber completely.

Typically, the control curve of the control valves is calculated by the controller. The calculated values are used for the control of the at least one control valve. Also, it is possible that the optimized control curve will be stored in the controller so that it is possible to control the valves according to the stored control curve.

According to the embodiments described herein, the venting time can be significantly reduced. In modem inline coating systems such as display coatings, the venting time in the lock chamber has become the dominant time factor of the overall cycle time. Whereas typical times for the evacuation of load lock chambers in fast systems can reach values of below 5 sec, the time involved for venting the unload lock chamber may be larger than that resulting in a slowdown of the overall cycle time of the coating process. In the art, fast venting often resulted in the damage or destruction of the substrates. The present disclosure provides an apparatus and a method that allows fast venting of the unload lock chamber thereby reducing the overall cycle time of the inline coating process. This, in turn, increases the overall productivity, and thus decreases the costs. For instance, it is possible to reduce the venting time from 10 sec as necessary in the art to 8 sec, 6 sec or even 2 sec.

Furthermore, since "soft venting" techniques typically included the provision of additional valves that were opened subsequently during venting (typically of up to six valves), the present disclosure allows the reduction of the number of valves, e.g. to only one valve, or to one valve per substrate side. Thus, the mechanical complexity and the control effort is reduced.

While the foregoing is directed to embodiments of the invention, other and further embodiments of the invention may be devised without departing from the basic scope thereof, and the scope thereof is determined by the claims that follow.

## Claims

1. A lock chamber (10) for a substrate processing system (100), comprising:
at least a first conduit (18, 28, 58, 59) adapted to provide an inner portion (12) of the lock chamber in fluid communication with atmospheric pressure or
overpressure; and
at least a first control valve (15, 16, 55) for controlling a flow rate of the fluid communication of the inner portion of the chamber with the atmospheric pressure or the overpressure, the control valve being adapted to continuously control the flow rate.

2. The lock chamber according to any of the preceding claims, wherein the lock chamber is an unload lock chamber for providing the transition between low pressure and atmospheric pressure.

3. The lock chamber according to any of the preceding claims, further comprising a controller (30) adapted for calculating an optimized flow rate and/or for reading stored flow rate information from a database, wherein the controller is optionally connected to the first control valve (15, 16, 55).

4. The lock chamber according to any of the preceding claims, further comprising at least one measurement unit (60) with the measurement unit being optionally selected from one or more of the following:
a sensor for determining the position and/or vibration of a substrate;
a flow sensor for determining the flow within the chamber; and
a pressure sensor for sensing the pressure within the chamber;
wherein the at least one measurement unit is optionally positioned in close distance to the substrate.

5. The lock chamber according to claim 4 if dependent on claim 3, wherein the measurement unit is connected to the controller (30) in order to provide the controller with measurement data constantly.

6. The lock chamber according to any of the preceding claims, further comprising:
a second conduit (28) adapted to provide an inner portion of the chamber in fluid communication with atmospheric pressure; and/or
a second control valve (16) for controlling the flow rate of the fluid communication of the inner portion of the chamber with the atmospheric pressure, the control valve being adapted to continuously control the flow rate.

7. The lock chamber according to any of the preceding claims, further comprising:
at least one on/off-valve (95, 96, 97) for completely opening or closing the flow to the inner portion of the chamber.

8. A substrate processing system (100) comprising at least one lock chamber (10, 80) according to any of the proceeding claims and a chamber (81, 102) for coating a substrate.

9. A method of venting a lock chamber, comprising:
providing a flow rate profile for venting the lock chamber; and
controlling a first control valve being adapted to continuously control the flow rate according to the flow rate profile for venting the lock chamber.

10. The method according to claim 9, further comprising one or more of the following:
sensing the position and/or vibration of a substrate;
sensing the flow within the chamber at at least one position; and
sensing the pressure within the chamber at at least one position;
wherein the method optionally further comprises reducing or increasing the flow rate dependent on the sensing.

11. The method according to any of claims 9-10, further comprising controlling a second control valve being adapted to continuously control the flow rate according to the flow rate profile for venting the lock chamber.

12. The method according to any of claims 9-11, further comprising calculating an optimized flow rate and/or reading stored information on the optimized flow rate, thereby optionally accounting for measurement data obtained during sensing.

13. The method according to any of the preceding claims, further comprising controlling at least one on/off-valve for completely opening or closing a flow to the inner portion of the chamber.

14. Computer program comprising computer program code means adapted to perform all the steps of the method of any of the claims 9-13 when the program is run on a computer.

15. A computer-readable medium storing the computer program according to claim 14.
